# EUROPEAN PATENT APPLICATION

(11) **EP 0 600 604 A1**
(43) Date of publication of application: **08.06.1994**
(21) Application number: 93308531.8
(22) Date of filing: 26.10.1993
(51) Int. Cl.: G01R 1/04, G01R 31/28

(54) **Apparatus and process for bare chip test and burn-in**

(30) Priority: 30.10.1992 US 968740
(71) Applicant: TEXAS INSTRUMENTS INCORPORATED, Dallas Texas 75265 (US)
(72) Inventor: Chiu, Anthony M., Richardson, TX 75082 (US)
(74) Representative: Nettleton, John Victor

(57) **Abstract**

The invention is to an apparatus and method for testing and burn-in of bare semiconductor chips. A molded chip carrier (10) of a high temperature plastic is utilized as a temporary holder for the chip. The carrier also has three alignment holes (15, 16, 119) that correspond to the alignment pins (24, 25, 27) in a test socket (20). The contact pads on the chip are aligned to contacts in the test socket (20) utilizing the alignment holes and pins. Before starting the testing and burn-in process, the carrier (10) with a chip is loaded into the socket (20), with the contact pads on the chip facing the tips of the contact elements in the socket. The carrier (10) is inserted into the socket (20) using the alignment pins (24, 25, 27) and holes (15, 16, 19) as guides. Clamping force is applied by the lid to ensure that the contacts of the socket maintain adequate contact force with the device contact pads during burn-in and testing. After burn-in and testing, the carrier (10) with the chip attached to it is removed from the socket (20).

## Description

### FIELD OF THE INVENTION

This invention relates to semiconductor devices, and more particularly an apparatus and method for testing and burn-in of bare semiconductor chips without a package.

### BACKGROUND OF THE INVENTION

Many semiconductor devices, and particularly DRS are sold only after burn-in, and retested to locate devices which fail prematurely. Most DAS are burned-in and tested after the chip is packaged, either molded in plastic or TAB. When packaged devices are found to be defective, the cost of not only the semiconductor chip, but the packaging material and labor in packaging the device is lost. For high performance systems such as multi chip modules, a pre-tested and burn-in chip is needed to improve assembly yield and to minimize repair/replacement cost. For reasons stated above, bare chip test and burned-in have been developed by many manufactures using different technologies.

### SUMMARY OF THE INVENTION

The invention is to an apparatus and method for testing and burn-in of bare semiconductor chips. A molded chip carrier of a high temperature plastic is utilized as a temporary holder for the chip. The carrier design matches the body dimension of conventional packages such as Dual-In-Line package (DIP) or Thin-Small-Outline Package (TSOP), so that the carrier is compatible with conventional handling equipment used in integrated circuit assembly.

The carrier has a recessed pocket slightly larger than the bare chip. At the bottom of the recess, a thin layer or sheet of low tack adhesive is placed to secure the bare chip in the carrier. An opening in the bottom side of the recess allows the passage of a mechanical tool to push the bare chip out of the carrier before putting the chip on the printed circuit board or substrate. The adhesive only holds the chip in place and does not securely bond the chip to the carrier. The carrier also has three alignment holes that correspond to the alignment pins in a test socket. The chip is placed onto the bottom of the carrier using an optical align and place method. The three holes form the horizontal and vertical XY axes. The bond pads on the chip also form another XY axes for alignment. The optical align-and-place machine makes adjustments to the offsets in both the X and Y axes to account for virtual distance and mechanical placement errors. The chip is then placed into the carrier similar to conventional pick-and-place techniques by assembly equipment. The contact pads on the chip are aligned to contacts in the test socket utilizing the alignment holes and pins.

Before starting the testing and burn-in process, the carrier with a chip is loaded into the socket, with the contact pads on the chip facing the tips of the contact elements in the socket. The carrier is inserted into the socket using the alignment pins and holes as guides. Clamping force is applied by the lid to ensure that the contacts of the socket maintain adequate contact force with the device contact pads during burn-in and testing. After burn-in and testing, the carrier with the chip attached to it is removed from the socket. Further testing may be done while the bare chip is in the carrier. The semiconductor chips are then shipped to the customer in the carrier or in the socket. The carrier may be heated to make removal of the bare chip from the carrier easier and to ensure that the chip is not broken during removal.

The technical advance represented by the invention, as well as the objects thereof, will become apparent from the following description of a preferred embodiment of the invention when considered in conjunction with the accompanying drawings, and the novel features set forth in the appended claims.

### BRIEF DESCRIPTION OF THE DRAWINGS

FIGURE 1 shows a bare chip and a carrier before placement;
FIGURE 2 shows a socket for testing the bare chip;
FIGURE 2A is a cross-section through section A-A of FIGURE 2 shown the contact configuration;
FIGURE 3 shows a multi-socket test fixture or burn-in board;
FIGURE 4 is a cut-away top view of a socket with a chip and carrier therein;
FIGURE 5 is a side view in cross-section taken through section B-B of FIGURE 4;
FIGURE 5a is an enlarged of the barbed stud of FIGURE 5; and
FIGURE 6 shows a cross-section of socket of FIGURE 5 secured to a printed circuit board, and showing contact to the printed circuit board.

### DESCRIPTION OF A PREFERRED EMBODIMENT

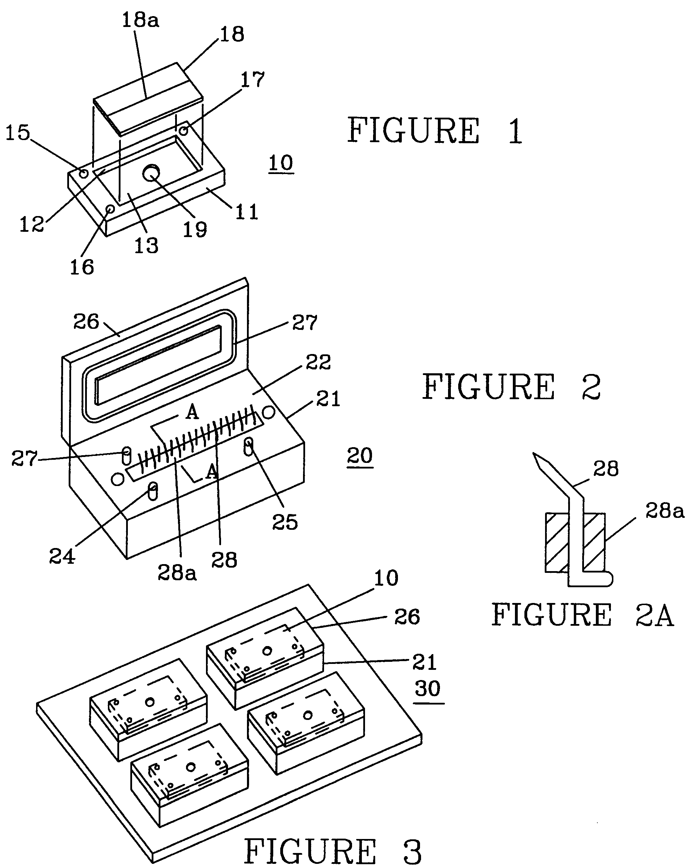

FIGURE 1 shows the bare chip carrier 10. Carrier body 11 has a recess 12 therein for receiving bare chip 18. Carrier body 11 has three locking holes 15, 16 and 17 for aligning the chip to the carrier. These holes are also used to align the carrier to the contacts in the test socket as described below. Slots in the edge of the carrier may also be used for alignment purposes. A tacky adhesive (not shown) is placed on surface 13 of recess 12. The adhesive is used to temporarily adhere bare chip 18 in recess 12. Bare chip 18 is placed in recess 12 with contacts 18a up. Clearance hole 19, in the recess surface 13 is used to push bare chip 18 out of recess 12 mechanically. Carrier body 11 and bare chip 18 may be heated up slightly to reduce the adhesive force to release bare chip 18 so that the chip can be removed from the carrier body 11 with minimum force. The carrier is molded from a plastic having low thermal coefficient of expansion that matches the bare chip. The plastic is a commercially available product from Hoechst Celanese called Liquid Crystal Polymer.

FIGURE 2 shows a socket 20 used in conjunction with bare chip carrier 10. The socket of FIGURE 2 has a hinged lid 26. The hinges are not illustrated. Socket 20 has a body 21 with three alignment pins 23, 24 and 25 on surface 22. Alignment pins 23, 24 and 25 are used to guide the carrier by mating with holes 15, 16 and 17 of carrier body 11 when carrier 10 is being inserted into socket 20. Contacts 28 have the same spacing as contact pads 18a on bare chip 18. An 0-ring seal 27 seals top 26 to socket body 21 when chip carrier 10 with bare chip 18 is placed into socket 20. By closing top 26 to socket body 21 during burn-in of bare chip 18, bare chip 18 is not contaminated by particles and organic matters outside the socket. The socket body is cleaned by chemicals that dissolve the organic matter resulting from molding. Contacts 28 are molded in a plastic with low coefficient of thermal expansion such as Liquid Crystal Polymer by Hoechst Celanese.

FIGURE 2a shows the cross-section of the contact element. The contacts 28 are molded and held together by 28a, which is inserted into contact body 21 during assembly.

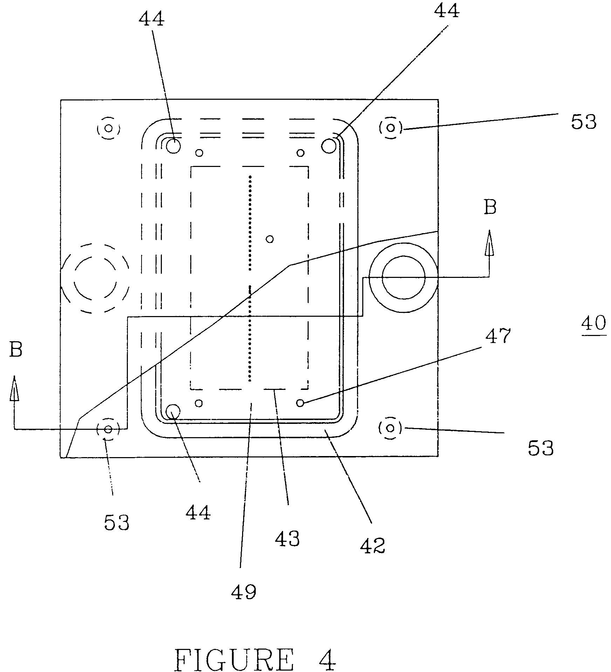

FIGURE 3 illustrates a multi-socket test fixture for testing and burn-in of, for example, four bared chips at a time. Fixture 30 is a printed circuit wiring board 31 with four socket bodies 21 mounted there. Top 26 is closed with bare chip carrier 10 placed inside.

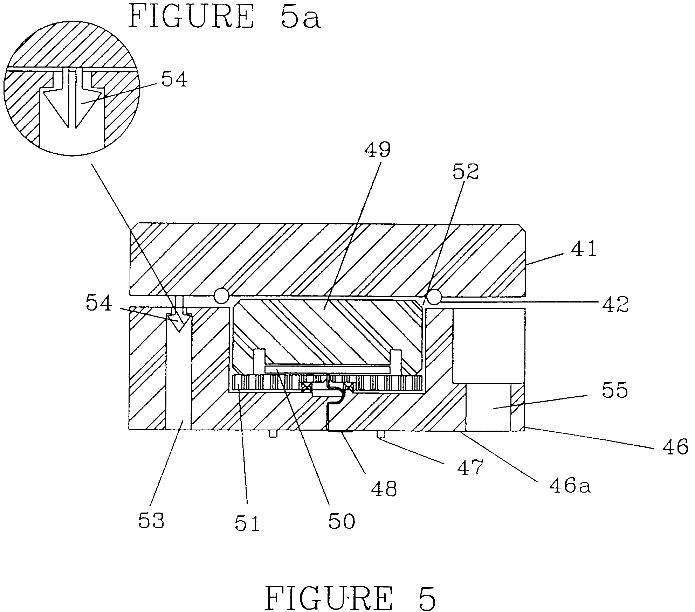

FIGURE 4 is a top view of an alternate socket configuration used with the bare chip carrier in testing the bare chip, and FIGURE 5 is a cross sectional view taken though section A-A. Top 41 is sealed against housing 46 with 0-ring 42. Carrier 49 with bare chip 50 is placed in recess 52 in socket housing 46. In the bottom of recess 52 is comb S1 holding in position contacts 48 therein. Bare chip 50 is mounted in carrier 49 so that contact pad on bare chip 50 are against contacts 48 when carrier 49 is inserted in housing 46. On the bottom 46a of body 46 are standoffs 47 providing alignment of the socket housing to the printed wiring board (not illustrated).

After inserting the carrier into the socket, the lid 41 with O-ring seal is placed over the housing. Lid 41 utilizes four barbed studs 54, shown enlarged in figure 5a, to guide into the retainer holes 53 in the housing. Barbed stud 54 has a slot which separates the two halves of the stud. When it is time to remove the carrier from the housing, the barbed studs are squeezed together to clear the restricting section of the retainer hole 53 and pushed out of the hole.

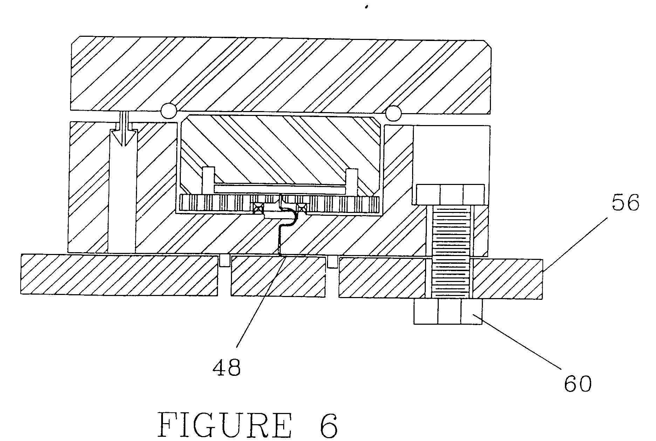

FIGURE 6 shows the mounting of the socket onto a printed wiring board 56 using 2 screws and two nuts. The contact element is pressed onto the printed wiring board by tightening the screws 60.

The printed wiring board circuit has a circuit pattern that matches the position of the contact elements 48. The socket is attached to the printed circuit board without soldering. This enables the removal of the socket form the board after testing and burn-in at the factory. The socket can be remounted onto another test fixture for additional tests. Therefore, the chip can be tested in multiple configurations without being removed form its carrier. A significant advantage of this design is the elimination of multiple probing of the contact pads on the chip. The integrity of the bond pads is maintained in the present invention. No damage results from placing the bare chip in the carrier and positioned in the socket. Multiple probing has proven to be damaging to the bond pad and reduces assembly yield at wire bonding.

## Claims

1. A semiconductor chip carrier for holding a bare semiconductor chip, having contacts on one side of said chip, during burn-in and test, comprising:
a rectangular carrier body;
a recessed opening in a first side of the carrier body, having a bottom surface, for receiving a bare chip; and
an adhesive on the bottom surface for holding the bared chip in the recessed opening.

2. The carrier according to claim 1, including an opening in the bottom surface extending through the carrier to a second side of the carrier.

3. The carrier according to claim 1, including locating holes in said first side of the carrier body, said locating holes providing reference locations to enable a pick-and-place machine to place the bare chip in the recessed opening.

4. The carrier according to claim 3, wherein said locating holes are slots formed in the side of the carrier body.

5. The carrier according to claim 1, where the thermal expansion characteristics of the carrier is a close match to that of the bare chip mounted in the carrier.

6. The carrier according to claim 1, wherein the carrier body has dimensions the same as a packaged integrated circuit package.

7. The carrier according to claim 1, in combination with a socket, the socket comprising:
a socket body,
a set of contacts on a first side of the socket body in a pattern corresponding to the contacts on the bare chip;
an O-ring enclosing the set of contacts; and
a set of locating pins corresponding to locating holes in the carrier.

8. The socket according to claim 7, wherein said contacts extend through the socket body to a second side of the socket body for contacting a printed circuit board for testing and burn-in.

9. The socket according to claim 7, wherein said contacts each have a tapered tip for alignment to contact pads on said bare chip.

10. The socket according to claim 9, wherein said contacts are guided by a comb structure.

11. The socket according to claim 9, wherein the comb structure is molded from plastics that is a close match to the bare chip's thermal expansion.

12. The socket according to claim 9, wherein the contact elements are molded from and held together by plastics that is a close match to the bare chip's thermal expansion.

13. The socket according to claim 7, including locating studs to align contacts on a printed circuit board with the contacts of the socket.

14. A semiconductor chip carrier in combination with a socket for holding a bare semiconductor chip during burn-in and testing of the bare semiconductor chip, said chip having contact pads on one side of, comprising:
a rectangular carrier body;
a recessed opening in a first side of the carrier body, having a bottom surface, for receiving a bare chip;
a socket body having first and second sides;
a set of contacts extending from said first side, through the socket body, to said second side, said set of contacts corresponding number and arrangement to the contacts on said semiconductor chip;
wherein said bare chip in said carrier is secured to said socket, the contact pads on said chip held in contact with the set of contacts on said socket.

15. The combination according to claim 14, including an opening in the bottom surface of said carrier body extending through the carrier to a second side of the carrier.

16. The combination according to claim 14, including locating holes in said first side of the carrier body, said locating holes providing reference locations to enable a pick-and-place machine to place the bare chip in the recessed opening.

17. The combination according to claim 14, where the thermal expansion characteristics of the carrier is a close match to that of the bare chip mounted in the carrier.

18. The combination according to claim 14, wherein the carrier body has dimensions the same as a packaged integrated circuit package.

19. A method for mounting a bare semiconductor chip, with contact pads in a pattern on one side, for burn-in and testing, comprising the steps of:
mounting the bared chip in a recess in a carrier;
clamping the carrier against a socket having contacts in number pattern corresponding to the contact pads on the bared chip;
contacting the socket with a printed circuit board; and
performing burn-in and test on the bare chip.

20. The method according to claim 19, including adhering the bare chip in the recess on the carrier with a tacky adhesive.

21. The method according to claim 19, wherein said bare chip is placed in the recess in the carrier by optical align-and-place machine which makes adjustments in X and Y axes to account for virtual distance and mechanical placement errors.

22. The method according to claim 19, wherein the bare chip in the carrier and socket is transferred from burn-in circuit board to a test board for testing.

23. The socket and carrier combination according to claim 14, wherein the carrier serves as a shipping package.

24. The socket and carrier combination according to claim 14, wherein the carrier and socket serve as a shipping package.

25. The socket and carrier combination according to claim 14, wherein the socket, carrier and test board on which the socket is mounted is shipped as a unit.
